# EUROPEAN PATENT SPECIFICATION

(11) **EP 0 764 853 B1**
(45) Date of publication and mention of the grant of the patent: **21.04.1999**
(21) Application number: 96401858.4
(22) Date of filing: 29.08.1996
(51) Int. Cl.: G01R 33/383, G01R 33/3873, G01R 33/385

(54) **Magnet assembly in MRI instrument**
Magnetanordnung in einem Gerät für die bildgebende magnetische Resonanz
Ensemble d'aimants dans un appareil pour l'imagerie par résonance magnétique

(30) Priority: 19.09.1995 JP 239530/95
(43) Date of publication of application: 26.03.1997
(73) Proprietor: SHIN-ETSU CHEMICAL CO., LTD., Chiyoda-ku Tokyo (JP)
(72) Inventor: Yoneda, Yuhito, c/o Shin-Etsu Chem. Co., Ltd., Takefu-shi, Fukui-ken (JP); Ohashi, Ken, c/o Shin-Etsu Chem. Co., Ltd., Takefu-shi, Fukui-ken (JP); Miyata, Koji, c/o Shin-Etsu Chem. Co., Ltd., Takefu-shi, Fukui-ken (JP); Higuchi, Dai, c/o Shin-Etsu Chem. Co., Ltd., Takefu-shi, Fukui-ken (JP)
(74) Representative: Armengaud Ainé, Alain

(56) References cited:
- US-A- 4 631 481
- US-A- 5 061 897
- US-A- 5 363 078
- PATENT ABSTRACTS OF JAPAN vol. 014, no. 270 (C-0727), 12 June 1990 & JP-A-02 080033 (TOSHIBA CORP), 20 March 1990,

## Description

### BACKGROUND OF THE INVENTION

The present invention relates to an improvement in a novel magnet assembly in magnetic resonance imaging instruments such as medical MRI instruments with permanent magnets capable of generating a highly uniform magnetic field in the space between the oppositely facing permanent magnets.

The magnet assembly in a magnetic resonance imaging instrument with permanent magnets used, for example, for the purpose of medical diagnosis, referred to as an MRI instrument hereinafter as the major current in recent years is that having a pair of strong permanent magnets, such as a rare earth-based permanent magnet, disposed in up and down symmetry to face oppositely each to the other forming a gap space for magnetic field generation therebetween in which the patient lies for medical inspection by imaging. It is very important there in order to ensure reliableness of the diagnosis that, needless to say, the magnetic field generated in the gap space between the opposed permanent magnets, referred to as the magnet gap space hereinafter, is very uniform as highly as possible so as to ensure sharpness of the images. In this regard, it is a common practice that a pole piece made from a magnetically soft material, such as soft iron and the like, is mounted on the surface of each of the opposed permanent magnets to face the magnet gap space. While it is necessary to generate a gradient magnetic field in the magnet gap space to accomplish magnetic resonance imaging by means of a magnetic modulating means such as a gradient-field coil mounted on the pole piece, a problem in this case is that the uniformity of the magnetic field is disturbed by the residual magnetization in the pole pieces resulting in a decrease in the sharpness of the images or distortion thereof.

Occurrence of the above mentioned residual magnetization in the pole pieces is a phenomenon more or less unavoidable in any magnetic materials as a consequence of the magnetic hysteresis however magnetically soft the magnetic material of the pole pieces may be. It is a conventional measure therefor that the pole pieces are made, in place of or in combination with a soft iron, from silicon steels, soft ferrites, Permalloys and the like magnetically softer than soft irons in order to decrease the residual magnetization in the pole pieces (see, e.g., US-A-5 061 897). Although the residual magnetization in the pole pieces can of course be decreased by increasing the amount of these highly soft magnetic materials such as silicon steels, soft ferrites, Permalloys and the like, these magnetic materials cannot be used practically in large amounts because of their expensiveness as compared with conventional soft irons so that the improvement in the imaging quality by a decrease in the residual magnetization of the pole pieces can be accomplished only with an increase in the manufacturing costs of the MRI instrument.

### SUMMARY OF THE INVENTION

The present invention accordingly has an object, in view of the above described problems and disadvantages in the prior art magnet assemblies, to provide a novel and improved magnet assembly in an MRI instrument, in which the adverse influences on the quality of the magnetic resonance images due to the residual magnetization in the pole pieces can be greatly reduced without substantially increasing the manufacturing costs of the MRI instrument.

Thus, the present invention provides a magnet assembly in an MRI instrument which comprises;
(a) a pair of permanent magnets oppositely disposed to face each to the other with a magnet gap space therebetween, a static magnetic field being generated thereby in the magnet gap space;
(b) a pair of pole pieces each mounted on one of the permanent magnets to face the magnet gap space;
(c) a pair of magnetic modulating coils to generate a gradient magnetic field relative to the static magnetic field generated by the permanent magnets, each being mounted on one of the pole pieces to face the magnet gap space; and which is characterized by
(d) a pair of magnetic-field compensation members made from a ferromagnetic material having a coercive force not exceeding 7958 A/m (100 Oe), each member being mounted on one of the magnetic modulating coils to face the magnetic gap space.

In particular, the above mentioned magnetic field compensation member is a disc or circular sheet made from a magnetically soft ferromagnetic material such as a soft iron and has a thickness in the range from 0.005 mm to 0.5 mm.

### BRIEF DESCRIPTION OF THE DRAWING

Figure 1 is a schematic transverse cross sectional view of a conventional magnet assembly in an MRI instrument.

Figures 2 and 3 are each a schematic transverse cross sectional view of the pole piece and gradient-field coil in the lower half of the magnet assembly illustrated in Figure 1 showing the residual magnetization of the pole piece when a gradient magnetic field is applied in the X-direction and Z-direction, respectively, in Figure 1.

Figure 4 is a schematic transverse cross sectional view of the main part of the lower half of the inventive magnet assembly having a magnetic-field compensation member.

### DETAILED DESCRIPTION OF THE PREFERRED EMBODIMENTS

As is mentioned above, occurrence of residual magnetization in the pole pieces is a more or less unavoidable phenomenon as a consequence of the magnetic hysteresis possessed by any magnetic materials including the magnetically soft magnetic materials from which the pole pieces are made. The primary idea of the inventors leading to the present invention is that the adverse influences due to the residual magnetization in the pole pieces could be compensated for by providing a magnetic compensation means in which residual magnetization can be induced to give a compensating magnetic field to the magnetic field in the magnet gap space in an inverse direction to that of the magnetic field due to the residual magnetization in the pole pieces, the absolute values of the two magnetic fields being substantially identical.

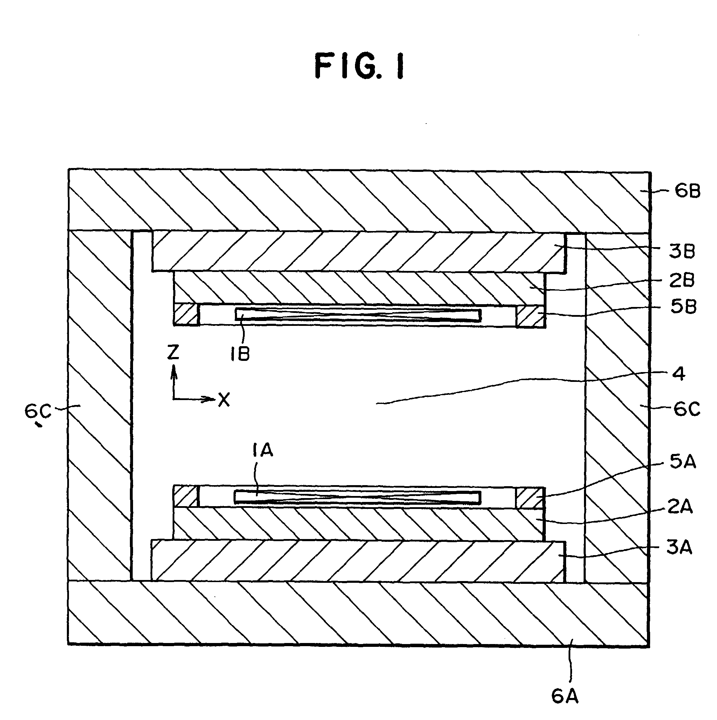

Figure 1 of the accompanying drawing is a schematic transverse cross sectional view of a conventional magnet assembly in an MRI instrument of the opposed-magnet type, in which a pair of permanent magnets 3A, 3B are disposed symmetrically up and down on the respective base yokes 6A, 6B to face each to the other forming a magnet gap space 4 therebetween by connecting the base yokes 6A, 6B with connecting yokes 6C. A pair of pole pieces 2A, 2B made from a soft magnetic material are mounted on the respective permanent magnets 3A, 3B to face the magnet gap space 4. Each of the pole pieces 2A, 2B has a circular rib 5A, 5B along the periphery of the circular pole piece 2A, 2B with an object to improve the uniformity of the magnetic field in the magnet gap space 4. As a means to generate a gradient magnetic field in the magnet gap space 4, it is usual that a gradient-field coils 1A, 1B are mounted each on the surface of the pole pieces 2A, 2B as surrounded by the circular rib 5A, 5B. The height of the gradient-field coil 1A, 1B is usually smaller than that of the circular rib 5A, 5B in order that the effective height of the magnet gap space 4 is decreased by the gradient-field coils 1A, 1B as a magnetic field-modulating means.

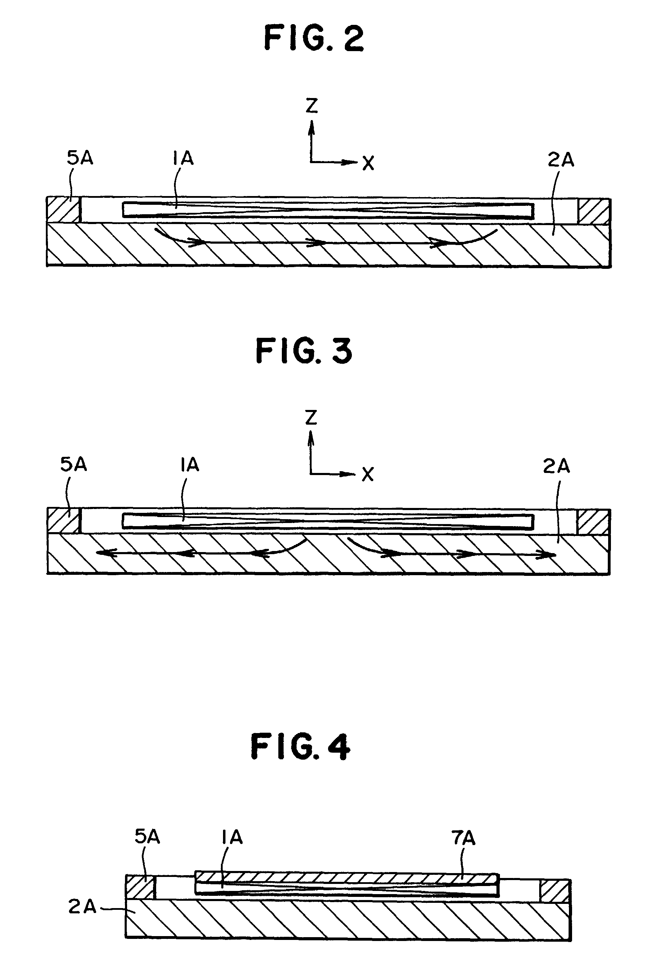

When a gradient magnetic field is generated by energizing the gradient-field coils 1A, 1B, the pole pieces 2A, 2B are magnetized in the direction indicated by the arrows in Figures 2 and 3 showing the pole piece 2A and gradient-field coil 1A in the lower half of the assembly. This is the phenomenon of residual magnetization which influences the uniformity of the magnetic field. The idea leading to the invention is accordingly that the adverse influences due to the residual magnetization of the pole pieces 2A, 2B could be compensated for if a magnetic compensating means is provided to each of the pole pieces 2A, 2B, of which the direction of the residual magnetization is reversed to that of the pole piece 2A or 2B and the contribution thereof to the magnetic field in the magnet gap space 4 is approximately equal to that by the residual magnetization in the pole piece 2A, 2B in the absolute value.

Namely, the present invention proposes, as the magnetic compensating means mentioned above, to provide a magnetic-field compensation member 7A, 7B made from a ferromagnetic material on each of the gradient-field coils 1A, 1B to face the magnet gap space 4. Since the magnetic-field compensation member 7A, 7B is located on the opposite side of the gradient-field coil 1A, 1B relative to the pole piece 2A, 2B, the direction of the residual magnetization therein is reverse to that of the pole piece 2A, 2B. Accordingly, the magnetic field due to the residual magnetization in the magnetic-field compensation member 7A, 7B is compensatory for the magnetic field due to the residual magnetization in the pole piece 2A, 2B.

When the magnetic fields due to the pole pieces 2A, 2B and the ferromagnetic compensation members 7A, 7B are identical in the absolute values, therefore, it can be expected that the adverse influences due to the residual magnetization in the pole pieces 2A, 2B can be completely canceled. Since the magnetic-field compensation member 7A, 7B on the gradient-field coil 1A, 1B to face the magnet gap space 4 is located at a position closer to the magnet gap space 4 than the pole piece 2A, 2B below the gradient-field coil 1A, 1B and the strength of the magnetic field at a point due to a magnetic pole is inversely proportional to the distance between the point and the magnetic pole, it is readily understood that the residual magnetization in the magnetic-field compensation member 7A, 7B can be smaller than the residual magnetization in the pole piece 2A, 2B.

A problem has to be taken into consideration in connection with the magnetic-field compensation member 7A, 7B installed on the gradient-field coil 1A, 1B to face the magnet gap space 4. Namely, the magnetic-field compensation member 7A, 7B serves as a magnetic path for the magnetic flux generated by the gradient-field coil 1A, 1B so that the effective magnetic field in the magnet gap space 4 due to the gradient-field coil 1A, 1B is necessarily decreased by the absorption of the magnetic flux in the magnetic-field compensation member 7A, 7B resulting in a decrease in the efficiency of gradient-field generation by the coils 1A, 1B. This problem can be solved mostly when the magnetic-field compensation member 7A, 7B is magnetized to be near to magnetic saturation as the member 7A, 7B is in the magnetic field generated by the gradient-field coil 1A, 1B because a magnetically saturated body exhibits an effect of magnetic flux absorption no more than air so that the efficiency of the gradient-field coil 1A, 1B for the generation of the gradient magnetic field in the magnet gap space 4 is little decreased.

The magnetic-field compensation member 7A, 7B mounted on the gradient-field coil 1A, 1B is made desirably from a magnetic material having a low coercive force of, for example, 7958 A/m (100 Oe) or lower in order readily to reach magnetic saturation by the magnetic field generated by the gradient-field coil 1A, 1B. Suitable ferromagnetic materials in this regard include soft irons, silicon steels, soft ferrites, Permalloys and the like. Since the gradient magnetic field by the gradient-field coil 1A, 1B is generated not continuously but pulse-wise, it is important for the magnetic-field compensation members 7A, 7B, as in the pole pieces 2A, 2B likewise, to be designed and constructed in such a fashion that the eddy current due to the application of pulsed magnetic field can be minimized in order to avoid degradation of the quality of the magnetic resonance images along with the means to decrease the residual magnetization..When the magnetic-field compensation member 7A, 7B is a lamination of thin sheets of a metallic material such as a soft iron, silicon steel, Permalloy and the like having low electric resistance, the eddy current can be reduced by dividing the member into small portions electrically insulated each from the others or by providing interlayer insulation between the sheets. It is advantageous in this regard that the magnetic-field compensation member 7A, 7B of such a composite structure is designed with a ferromagnetic material having high electric resistance such as soft ferrites in combination with a metallic ferromagnetic material.

The magnetic-field compensation members 7A, 7B each have a configuration of a disc, like the pole pieces 2A, 2B, in order that the residual magnetization therein is symmetrical to that in the pole pieces 2A, 2B though not particularly limitative thereto with optional modification in compliance with the configuration of the gradient-field coils 1A, 1B and other parts. When the magnetic-field compensation member 7A, 7B is in the form of a disc, the thickness of the disc is preferably in the range from 0.005 mm to 0.5 mm depending on the material thereof having different saturation magnetization. When the thickness is too small, no substantial compensating effect can be obtained thereby on the magnetic field due to the residual magnetization in the pole pieces 2A, 2B as a consequence of the very small residual magnetization thereof while, when the thickness is too large, the magnetization of the magnetic-field compensation member 7A, 7B as a whole can hardly reach saturation by the application of the gradient magnetic field resulting in a decrease in the efficiency of generation of the gradient magnetic field. In short, the magnetic-field compensation member 7A, 7B is designed to have such a thickness and surface area that the volume thereof is sufficiently large in order that the residual magnetization therein can fully compensate for the residual magnetization in the pole piece 2A, 2B within the above mentioned limits of the thickness.

When the magnetic-field compensation members 7A, 7B satisfying the above mentioned requirements are mounted on the gradient-field coils 1A, 1B, respectively, to face the magnet gap space 4, the magnetic field due to the residual magnetization in the pole pieces 2A, 2B can be fully compensated to exhibit an effect apparently equivalent to the reduction or disappearance of the residual magnetization even without undertaking any means to have the pole pieces 2A, 2B combined with an expensive material. The principle of the present invention is of course applicable to a magnet assembly in which the residual magnetization of the pole pieces is already small enough by undertaking an appropriate means therefor so as to further decrease the adverse influences of the residual magnetization in the pole pieces on the quality of the magnetic resonance images.

In the following, an embodiment of the present invention is described by way of an Example.

### Example.

A magnet assembly for an MRI instrument was constructed to have a structure generally in accordance with Figure 1, of which the pole pieces had a diameter of 1100 mm and the height of the magnet gap space 4 was 400 mm and the strength of the magnetic field at the center point of the magnet gap space 4 was 0.2 T. The gradient-field coils 1A, 1B were energized by passing such an electric current that the effective gradient magnetic field in the vertical direction was just ± 0.0001 T/cm and the non-uniformity in the magnetic field within the magnet gap space 4 was determined. The non-uniformity of the magnetic field implied here was a ratio obtained by dividing the difference in the magnetic field between two points, one, 10 cm above and, the other, 10 cm below the center point of the magnet gap space 4 by the magnetic field at the center point, i.e. 0.2 T. The non-uniformity here found was +14 ppm. The sign of + means that the magnetic field at the upper point was larger than the magnetic field at the lower point.

As an embodiment of the present invention, a magnetic-field compensation member 7A, 7B made from a 0.05 mm thick soft iron sheet having a diameter of 800 mm was mounted on each of the gradient-field coils 1A, 1B to face the magnet gap space 4 in the above described conventional magnetic assembly. The magnetic-field compensation member 7A, 7B was in the form of a disc which was divided into small pieces electrically insulated each from the others in order to decrease the eddy currents and to prevent a decrease in the efficiency of generation of the gradient magnetic field. The results of measurements undertaken under the same conditions as above excepting for the magnetic-field compensation members 7A, 7B were that the effective gradient magnetic field in the vertical direction was 0.000098 T/cm and the non-uniformity of the magnetic field was +3 ppm indicating a remarkable improvement in the uniformity of the magnetic field without substantially decreasing the effective gradient magnetic field.

To test the effect of the thickness of the magnetic-field compensation members 7A, 7B, the same experiment as above was repeated excepting replacement of each of the 0.05 mm thick magnetic-field compensation members with another magnetic-field compensation member which was a 1 mm thick lamination of the same soft iron sheets each electrically insulated from the adjacent sheets. The results of measurements undertaken under the same conditions as above excepting for the increase in the thickness of the magnetic-field compensation members were that the effective gradient magnetic field in the vertical direction was 0.000032 T/cm and the non-uniformity of the magnetic field was -44 ppm. The negative value of the non-uniformity indicated overcompensation of the residual magnetization in the pole pieces by the magnetic-field compensation members as a consequence of the excessively large thickness thereof. The great decrease in the effective gradient magnetic field was presumably due to absorption of a part of the magnetic flux from the gradient-field coils 1A, 1B by the magnetic-field compensation members 7A, 7B having a large thickness.

## Claims

1. A magnet assembly in a magnetic resonance imaging instrument which comprises;
(a) a pair of permanent magnets (3A,3B) oppositely disposed to face each other with a magnet gap space (4) therebetween, a static magnetic field being generated thereby in the magnet gap space;
(b) a pair of pole pieces (2A,2B) each mounted on one of the permanent magnets to face the magnet gap space;
(c) a pair of magnetic modulating coils (1A,1B) to generate a gradient magnetic field relative to the static magnetic field generated by the permanent magnets, each of the magnetic modulating coils being mounted on one of the pole pieces to face the magnet gap space;
and which is characterized by
(d) a pair of magnetic-field compensation members (7A,7B) having a thickness in the range from 0.005 mm to 0.5 mm made from a magnetically soft ferromagnetic material, each of the magnetic-field compensation members being mounted on one of the magnetic modulating coils to face the magnetic gap space.

2. The magnet assembly in a magnetic resonance imaging instrument as claimed in claim 1 in which the magnetically soft ferromagnetic material has a coercive force not exceeding 7958 A/m (100Oe).

## Patentansprüche

1. Magnetanordnung in einem Gerät für die bildgebende magnetische Resonanz aus
(a) einem Paar einander gegenüberliegender Dauermagnete (3A,3B) und dazwischen einem Magnetspalt (4), so daß in dem Magnetspalt (4) ein statisches Magnetfeld erzeugt ist;
(b) einem Paar an Polschuhen (2A,2B), die jeweils an einem der Dauermagnete (3A,3B) zur Seite des Magnetspalts (4) angeordnet sind;
(c) einem Paar an magnetischen Modulationsspulen (1A,1B) zur Erzeugung eines Gradienten-Magnetfeldes zu dem durch die Dauermagneten erzeugten statischen Magnetfeld, wobei die magnetischen Modulationsspulen (1A,1B) jeweils an einem der Polschuhe (2A,2B) zur Seite des Magnetspalts (4) angeordnet sind,
**gekennzeichnet** durch
(d) ein Paar an Magnetfeld-Kompensationselementen (7A,7B) mit einer Dicke im Bereich von 0,005 mm bis 0,5 mm aus einem weichmagnetischen Ferromagnetikum, wobei die Magnetfeld-Kompensationselemente (7A,7B) jeweils an einem der magnetischen Modulationsspulen (1A,1B) zur Seite des Magnetspalts (4) angeordnet sind.

2. Magnetanordnung in einem Gerät für die bildgebende magnetische Resonanz nach Anspruch 1,
dadurch **gekennzeichnet,**
daß das weichmagnetische Ferromagnetikum eine Koerzitivkraft aufweist, die 7958 A/m (100 Oe) nicht überschreitet.

## Revendications

1. Ensemble d'aimants dans un appareil pour imagerie par résonance magnétique qui comprend :
(a) une paire d'aimants permanents (3A, 3B) disposés en opposition pour se faire face l'un l'autre, un espacement étant formé entre les aimants (4), un champ magnétique statique étant génèré, de ce fait, dans l'espace formé entre les aimants ;
(b) une paire de pièces polaires (2A, 2B) montées, chacune, sur l'un des aimants permanents pour faire face à l'espacement entre les aimants ;
(c) une paire de bobines de modulation magnétique (1A, 1B) pour générer un champ magnétique à gradient par rapport au champ magnétique statique généré par les aimants permanents, chacune des bobine de modulation magnétique étant montée sur l'une des pièces polaires pour faire face à l'espace entre les aimants ; et qui esr
caractérisé par
(d) une paire d'éléments de compensation de champ magnétique (7A, 7B) présentant une épaisseur dans les limites de 0,005 mm à 0,5 mm, constitués d'un matériau ferromagnétique magnifiquement doux, chacun des éléments de compensation de champ magnétique étant monté sur l'une des bobines de modulation magnétique pour faire face à l'espace d'intervalle magnétique.

2. Ensemble d'aimants pour un appareil d'imagerie par résonance magnétique selon la revendication 1 dans lequel le matériau ferromagnétique magnétiquement doux possède une force coercive ne dépassant pas 7958 A/m (100 Oe).
